# EUROPÄISCHE PATENTSCHRIFT

(11) **EP 2 218 004 B1**
(45) Veröffentlichungstag und Bekanntmachung des Hinweises auf die Patenterteilung: **15.02.2012**
(21) Anmeldenummer: 08860195.0
(22) Anmeldetag: 10.12.2008
(51) Int. Cl.: G06F 11/20, H01L 21/00

(54) **VORRICHTUNG UND VERFAHREN ZUM REINIGEN VON GEGENSTÄNDEN**
APPARATUS FOR, AND METHOD OF, CLEANING ARTICLES
DISPOSITIF ET PROCÉDÉ DE NETTOYAGE D'OBJETS

(30) Priorität: 10.12.2007 WO PCT/EP2007/010734
(43) Veröffentlichungstag der Anmeldung: 18.08.2010
(73) Patentinhaber: RENA GmbH, 78148 Gütenbach (DE)
(72) Erfinder: DECHANT-WAGNER, Roland, 78056 Villingen-Schwenningen (DE); BÜRGER, Norbert, 79199 Kirchzarten (DE)
(74) Vertreter: Stürken, Joachim
(86) Internationale Anmeldenummer: PCT/EP2008/010460
(87) Internationale Veröffentlichungsnummer: WO 2009/074297

(56) Entgegenhaltungen:
- EP-A- 0 319 806
- EP-A- 1 935 514
- WO-A-2007/065665
- WO-A-2008/071364
- WO-A-2008/071365
- US-A1- 2004 089 325
- US-A1- 2006 060 232
- US-B1- 6 416 587

## Beschreibung

### Technisches Gebiet

Die Erfindung betrifft allgemein eine Vorrichtung und ein Verfahren zum Reinigen von dünnen und/oder bruchempfindlichen Scheiben, wie beispielsweise Halbleiterwafern, Glassubstraten, Fotomasken, Compactdiscs oder dergleichen. Insbesondere betrifft die Erfindung eine Vorrichtung und ein Verfahren zum Vorreinigen von Halbleiterwafern, nachdem diese durch Sägen aus einem Block hergestellt worden sind.

### Definitionen

Unter dem Begriff *"bruchempfindliche Scheiben"* werden erfindungsgemäß solche Gegenstände verstanden, die eine sehr geringe Dicke im Bereich zwischen 80 und 300 µm wie z.B. 150 bis 170 µm aufweisen. Die Form der Scheiben ist beliebig und kann beispielsweise im Wesentlichen rund (Halbleiterwafer) oder im Wesentlichen rechteckig bzw. quadratisch (Solarwäfer) sein, wobei die Ecken wahlweise eckig, abgerundet oder abgeschrägt ausgestaltet sein können. Diese Gegenstände sind aufgrund ihrer geringen Dicke sehr bruchempfindlich. Die Erfindung bezieht sich auf die Reinigung derartiger Gegenstände.

Die erfindungsgemäße Vorrichtung und das erfindungsgemäße Verfahren werden nachfolgend aus Verständnisgründen exemplarisch anhand von eckigen Solarwafern (kurz "Wafern") erläutert.

Die Erfindung beschränkt sich jedoch nicht nur auf die Reinigung von Wafern. Vielmehr umfasst die Erfindung allgemein die Reinigung von dünnen und/oder bruchempfindlichen Scheiben, die sequenziell in einem definierten Abstand zueinander in einer Trägereinrichtung gehalten werden.

### Hintergrund der Erfindung

Für die Herstellung von Wafern ist es notwendig, das Ausgangsmaterial, das in der Regel als rechteckiger Siliziumblock vorliegt und als Substratblock bzw. Ingot bezeichnet wird, auf eine Trägereinrichtung aufzubringen. Diese Trägereinrichtung besteht typischerweise aus einem Metallträger, auf dem wiederum eine Glasplatte als Trägermaterial angebracht ist. Dabei ist der zu bearbeitende Substratblock auf der Glasplatte aufgeklebt. Alternativ hierzu können jedoch auch andere Materialien für die Ausbildung der Trägereinrichtung vorgesehen sein.

Zur Herstellung mehrerer Wafer ist es notwendig, den Substratblock aus mono- oder polykristallinem Silizium scheibenartig vollständig durchzusägen, so dass der jeweilige Sägeschnitt bis in die Glasplatte hineinreicht. Nach dem Sägen z.B. unter Verwendung herkömmlicher Innenlochsägen oder Drahtsägen haftet der auf diese Weise hergestellte Wafer mit einer Längsseite (Kante), nämlich mit derjenigen, die der Trägereinrichtung zugewandt ist, durch die Klebeverbindung weiterhin an der Glasplatte. Nachdem der Substratblock vollständig in einzelne Wafer zerteilt worden ist und sich zwischen den einzelnen Wafern somit ein spaltartiger Zwischenraum gebildet hat, liegt der ursprüngliche Substratblock in Form eines kammartigen, fächerartigen Gebildes vor.

Zur Durchführung des nassmechanischen Sägeprozesses unter Verwendung einer Präzisionsdrahtsäge werden im Wesentlichen zwei Materialien benötigt, zum einen Siliziumcarbid oder gleichwirkende Partikel mit abrasiven Eigenschaften für die nötige Härte, zum anderen Glykol, Wasser oder auch Öl als Träger- und Kühlmittel. Korrekt betrachtet ist es gar nicht der Draht, der am Silizium sägt, sondern vielmehr sind es die Siliziumcarbidpartikel, die mit Glykol wie z.B. Polyethylenglykol oder Öl vermengt als sogenannte "Slurry" die Arbeit verrichten. Mit diesem gegebenenfalls weitere chemische Zusätze enthaltenden Medium wird der Draht während des Sägevorgangs gespült. Durch die Bewegung des Drahtes entfalten die Partikel ihre abrasive, d.h. abtragende Wirkung. So werden beispielsweise bei jedem Einschnitt mit einem 160-Mikrometer-Draht ca. 210 Mikrometer Silizium zerrieben. Dieser Verschnitt wird auch als Kerf bezeichnet und kann unter Verwendung dünnerer Drähte mit Durchmessern von z.B. 80 Mikrometer reduziert werden. Während des Sägeprozesses kommt es zu einer Vielzahl von chemischen Reaktionen der beteiligten Reaktionspartner auch an der Waferoberfläche. Zwischen den Wafern befinden sich nach dem Sägen Slurry, Reaktionsprodukte und Konglomerate aus Slurry-Bestandteilen und Silizium, die aufgrund ihrer Konsistenz häufig an der Oberfläche des Wafers anhaften.

Bevor die einzelnen Wafer, die nun jeweils eine scheibenförmige Ausbildung aufweisen, von der Trägereinrichtung entfernt werden, findet eine Reinigung statt. Durch die Reinigung soll die Slurry, die sich in den entstandenen Zwischenräumen jeweils zweier Substrate auf den Oberflächen der Wafer befindet, herausgewaschen werden. Diese Reinigung ist Gegenstand der vorliegenden Erfindung.

### Stand der Technik

Aus dem Stand der Technik sind Vorreinigungen zur Entfernung der Slurry bekannt. Sie werden in der Regel von Hand durchgeführt, indem ein Duschkopf, aus dem ein Fluidstrom austritt, von Hand über das kammartige Gebilde geführt wird. Dadurch wird erreicht, dass die in den Spalten des Substratblocks befindliche Slurry zumindest zum Teil ausgeschwemmt wird. Ein überwiegender Anteil verbleibt jedoch in dem spaltartigen Zwischenraum.

Diese manuelle Behandlung gestaltet sich jedoch schwierig, da die Trägereinrichtung von allen Seiten abzuduschen ist und ein Ablaufen der Slurry aufgrund des ständigen Drehens nur teilweise möglich ist. Zudem besteht gerade durch das ständige Wenden der Trägereinrichtung die Gefahr, dass die einzelnen Wafer von der Glasplatte abbrechen und zerstört werden.

Bis die Trägereinrichtung mit den Wafern einem nachfolgenden Bearbeitungsprozess übergeben werden kann, sind die Oberflächen der Wafer in der Regel bereits abgetrocknet. Ferner haftet dort weiterhin Slurry, wodurch der weitere Bearbeitungsprozess stark beeinflusst wird.

Ein gemeinsamer Nachteil dieser manuellen Behandlung liegt darin, dass eine gleichbleibende Qualität und damit standardisierbare und reproduzierbare Ergebnisse bezüglich der Oberflächeneigenschaften nicht gewährleistet werden können.

Ferner sind aus dem Stand der Technik auch automatisierte Vorrichtungen zur Reinigung derartiger Substrate bekannt. Diese Vorrichtungen betreffen zwar bereits scheibenförmige und dünne Substrate, sind jedoch nur bedingt auf die in jüngster Zeit zunehmend verwendeten höchst bruchempfindlichen, weil einerseits sehr dünnen, andererseits einen großen Durchmesser aufweisenden Substrate geeignet. Zudem weisen die bekannten Vorrichtungen auch den Nachteil auf, dass der Vorreinigung zusätzliche Reinigungsschritte nachzuschalten sind, um die Substrate bestimmungsgemäß weiterverarbeiten zu können.

Die WO 2008/071364 offenbart eine Vorrichtung sowie entsprechende Verfahren, mit denen die Reinigung dünner und/oder bruchempfindlicher Gegenstände wie beispielsweise Halbleiterwafern bereits hinreichend schonend vorgenommen werden kann.

### Aufgabe der Erfindung

Die Aufgabe der vorliegenden Erfindung liegt in der Optimierung der gemäß WO 2008/071364 offenbarten technischen Lehre, wobei die Optimierung die Reinigungsleistung des Gesamtsystems betrifft.

### Lösung der Aufgabe

Der Kerngedanke der Erfindung ist es, eine Vorrichtung und ein Verfahren zum Reinigen von dünnen und/oder bruchempfindlichen Wafern vorzuschlagen, mit denen der in unterschiedliche Verfahrensschritte gegliederte Reinigungsprozess selbsttätig (automatisch) durchlaufen wird.

Die erfindungsgemäße Vorrichtung ist Gegenstand des Anspruchs 1, während das erfindungsgemäße Verfahren durch die Merkmale des Anspruchs 10 definiert wird. Bevorzugte Ausführungsformen sind Gegenstand jeweiliger Unteransprüche.

### Beschreibung

Um ein weitgehendes Entfernen der Slurry aus den Zwischenräumen zu ermöglichen, wird eine Vorrichtung vorgeschlagen, die im Wesentlichen aus einer Trägereinrichtung, einer Duscheinrichtung, sowie einem Becken besteht.

Die Trägereinrichtung, die mindestens aus dem Trägermaterial besteht, auf dem der Substratblock aufgebracht ist, umfasst die durch Sägen des Substratblocks erzeugten dünnen Scheiben (wie bspw. Wafer). Diese sind sequenziell, d.h. nacheinander aufgereiht, wobei zwischen den einzelnen Wafern jeweils ein Zwischenraum ausgebildet ist. Die Wafer sind demnach mit ihrer einen Seite an einer Trägereinrichtung fixiert. Zwischen zwei benachbarten Wafern ist jeweils ein Zwischenraum ausgebildet. Die Duscheinrichtung ist derart ausgestaltet, dass sie vorzugsweise über die gesamte Längserstreckung der Wafer einen Fluidstrom überwiegend in die Zwischenräume erzeugt und somit Reinigungsfluid in die Zwischenräume einbringt. Der gesamte Reinigungsprozess ist in einem mit Fluid befüllbaren Becken vorgesehen. Das Becken ist derart bemessen, dass es die Trägereinrichtung aufnehmen kann. Während der erfindungsgemäßen Reinigungsschritte ist das Becken zumindest so weit mit Reinigungsflüssigkeit gefüllt, dass sich die Oberflächen der zu bearbeitenden Gegenstände in der Flüssigkeit befinden.

Die Ausgangslage des Reinigungsprozesses ist derart bestimmt, dass die Trägereinrichtung in eine "korbartige" Hilfseinrichtung der erfindungsgemäßen Vorrichtung übergeben wird. Die Ausgestaltung dieser Hilfseinrichtung ist grundsätzlich nicht festgelegt, solange gewährleistet ist, dass das Fluid die Zwischenräume zwischen den Wafern im Wesentlichen ungehindert erreichen kann und der Substratblock sowie gegebenenfalls abgelöste Wafer sicher gehalten werden. Nach einer bevorzugten Ausführungsform wird diese Einrichtung in Form zweier parallel zueinander in Längsrichtung verlaufender Stangenpaare bereitgestellt, wobei ein Paar als Auflage dient und ein weiteres Paar die Wafer seitlich stützt. Sobald die Hilfseinrichtung in die Vorrichtung eingebracht ist, ist das kammartige Gebilde des auf der Trägereinrichtung fixierten Substratblocks derart ausgerichtet, dass die Zwischenräume sowohl zu den Seitenwänden als auch zum Boden des Beckens offen und damit frei zugänglich sind. In dieser Ausgangslage befindet sich die Trägereinrichtung oberhalb der von ihr getragenen Substrate.

Dem nachfolgend dargelegten ersten Schritt des erfindungsgemäßen Reinigungsprozesses kann vorteilhafterweise eine Glykolvorlagerung der zu behandelnden Substrate vorgeschaltet sein.

Für den ersten Schritt des erfindungsgemäßen Reinigungsprozesses ist nun vorgesehen, eine Duscheinrichtung zu aktivieren. Die erfindungsgemäße Duscheinrichtung umfasst mindestens ein Duschelement, welches zweiteilig ausgestaltet ist, wobei jeweils ein Teil seitlich an einer Längsseite des Beckens derart angeordnet ist, dass beide Teile parallel zur Längsachse des Beckens verlaufen und hinsichtlich ihrer Strömungsrichtung gegenständig positioniert sind. Demnach ist die Duscheinrichtung derart ausgebildet, dass der Fluidstrom in die jeweiligen Zwischenräume zweier benachbarter Wafer gerichtet ist und die Verunreinigungen wegschwemmt. Ferner umfasst die erfindungsgemäße Vorrichtung eine alternierende Steuerung, mit der die beiden Teile des mindestens einen Duschelementes derart steuerbar sind, dass direkt gegenüber liegende Düsen nicht gleichzeitig aktiviert werden, wobei die Aktivierung das Ausgeben oder Absaugen von Fluid betrifft.

Das mindestens eine Duschelement bzw. ein Teil des zweiteiligen Duschelementes verfügt über eine Mehrzahl von Düsen (Öffnungen oder Bohrungen), die funktionell über mindestens eine Düsenleiste miteinander in Verbindung stehen und somit von demselben Flüssigkeitsvolumen gespeist ("aktiviert") werden können.

Erfindungsgemäß ist vorgesehen, dass die Düsen eines Teils des Duschelementes entweder mit einem Über- oder einem Unterdruck aktivierbar sind, wobei direkt gegenüber liegende Düsen des mindestens einen Duschelementes nicht gleichzeitig im selben Modus (Ausgeben / Absaugen) aktiviert werden.

In Abhängigkeit der Länge des zu bearbeitenden Substratblockes und des zur Verfügung stehenden Förderdruckes kann das Duschelement beidseitig in mehrere Segmente unterteilt sein, die ihrerseits durch das Vorhandensein jeweils einer Düsenleiste gekennzeichnet sind.

Die Position beider Teile des Duschelementes ist, gegebenenfalls getrennt voneinander, verstellbar. Sowohl die Höhe als auch der Abstand des Duschelementes oder eines seiner Teile oder Segmente vom Beckenrand ist verstellbar.

Dementsprechend kann wahlweise entweder die Duscheinrichtung relativ zur feststehenden Trägereinrichtung, oder die Trägereinrichtung relativ zur feststehenden Duscheinrichtung, oder sowohl die Trägereinrichtung als auch die Duscheinrichtung relativ zueinander bewegbar sein. Im Falle eines zweiteiligen Duschelementes ist es zwar bevorzugt, jedoch nicht zwingend erforderlich, dass die Bewegungen der einzelnen Teile gleichförmig wie insbesondere parallel oder gegenläufig zueinander erfolgen. Ggf. kann durch das nicht-parallele Bewegen auch eine Verbesserung des Reinigungsverhaltens erzielt werden. Ferner kann das Duschelement oder eines seiner Teile oder Segmente parallel zum seitlichen Beckenrand verfahren werden. Gewünschtenfalls kann die mindestens eine an einer Seite des Beckens angeordnete Düsenleiste eine oszillierende Bewegung ausführen, die wahlweise nach oben bzw. unten, vom Beckenrand weg bzw. zu ihm hin, und/oder parallel zum Beckenrand vor bzw. zurück gerichtet ist. Hierdurch können vorteilhafterweise eventuell vorhandene Inhomogenitäten in der Strömungscharakteristik ausgeglichen werden. Ein weiterer Vorteil der Oszillation parallel zur Achse der Düsenleiste liegt in der Vermeidung abweichender Strömungsverhältnisse, wie sie z.B. durch Verstopfung einzelner Düsen auftreten können. Durch diese Bewegungen werden zudem extrem aneinander haftende Substratverbände in Schwingung versetzt, wodurch die Reinigung der Zwischenräume derartiger Verbände verbessert wird.

Sofern erfindungsgemäß mehrere Duschelemente vorhanden sind oder eingesetzt werden, sind diese in Bezug auf die Tiefe des Beckens bevorzugt auf unterschiedlichen Niveaus angeordnet.

Die Düsenleiste ist vorzugsweise rechteckig ausgestaltet, wobei die zum gegenüberliegenden Beckenrand weisende Seite in ihrem oberen und/oder unteren Bereich besonders bevorzugt nach hinten abgeschrägt ist, wodurch die in den abgeschrägten Bereichen angeordneten Düsen leicht nach oben bzw. unten ausgerichtet sind und folglich nicht parallel zu den im mittleren Abschnitt angeordneten Düsen ausgeben können. Durch die abgeschrägten Bereiche wird bewirkt, dass Schmutzstellen zwischen zwei benachbarten Substraten noch wirksamer entfernt werden können. Vorzugsweise weisen die Düsenleisten jeweils mindestens einen Strombrecher auf, durch welche eine möglichst homogene Strömungscharakteristik über die gesamte Düsenleiste erreicht wird.

Um einen laminaren Strahl zu erzeugen, sind die Düsenbohrungen bevorzugt geometrisch definiert. Vorzugsweise sind die Düsenbohrungen kreisrund ausgebildet und weisen eine bevorzugte Querschnittsfläche von 0,1 bis 0,5, am meisten bevorzugt von 0,2 mm² auf, wobei sie bevorzugt kegelförmig ausgestaltet sind.

Nach einer alternativen bevorzugten Ausführungsform sind die Düsenbohrungen eher oval oder sternförmig ausgebildet. Diese Geometrie der Düsenbohrungen ermöglicht den passiven Eintrag von Gas in den Flüssigkeitsstrom, wodurch positive Auswirkungen auf das Reinigungsergebnis erzielt werden können.

Alternativ oder zusätzlich kann ein System vorgesehen sein, welches Gasblasen aktiv in den Strom der von den Düsen ausgegebenen Reinigungsflüssigkeit einbringt. Die Größe der von der erfindungsgemäßen Vorrichtung ggfs. erzeugten Gasblasen liegt bevorzugt im Bereich von 1 bis 500 µm.

Vorzugsweise sind die Düsen in einer jeweiligen Düsenleiste in Spalten und Zeilen angeordnet. Am meisten bevorzugt ist die Geometrie der Düsen derart ausgestaltet, dass ein möglichst weit reichender (z.B. 400 mm) Flüssigkeitsstrahl entsteht.

Erfindungsgemäß werden die beidseitig vorhandenen Düsenleisten des mindestens einen Duschelementes der Duscheinrichtung so gesteuert, dass die Flüssigkeit lediglich auf einer Seite ausgegeben wird, während die Düsen auf der anderen Seite keine Flüssigkeit ausgeben. Nach einer besonders bevorzugten Ausführungsform werden die Düsen auf der anderen Seite während dieser Zeit mit einem Unterdruck beaufschlagt (aktiviert), so dass Flüssigkeit durch sie abgesogen wird. Dabei ist es besonders vorteilhaft, wenn die Menge der auf der einen Seite ausgegebenen Flüssigkeit gerade der Menge der auf der anderen Seite abgesogenen Flüssigkeit entspricht. Durch diese koordinierte Aktivierung beider Seiten in unterschiedlichen Modi (Ausgeben / Absaugen) wird die Geschwindigkeit der durch die Düsen laminar ausgerichteten Strömung erhöht und somit das Reinigungsergebnis verbessert und/oder die zur Reinigung notwendige zu bewegende Flüssigkeitsmenge verringert. Nach kurzer Behandlungsdauer werden die Seiten gewechselt, sodass die Flüssigkeit alternierend von links bzw. rechts auf den Substratblock gerichtet wird. Sofern ein Teil des erfindungsgemäßen Duschelementes (eine Seite) mehrere Segmente mit jeweils einer Düsenleiste umfasst, ist auch hier sicherzustellen, dass direkt gegenüber liegende Düsen nicht gleichzeitig in demselben Modus aktiviert werden. Bei eng benachbarten Segmenten ist ggfs. darauf zu achten, dass einander benachbarte Segmente derselben Seite gerade nicht entgegengesetzt aktiviert werden, da ansonsten aus einem Segment ausgegebene Reinigungsflüssigkeit sofort vom benachbarten Segment aufgenommen würde, anstelle den erfindungsgemäß gewünschten Weg durch die Zwischenräume des Substratblocks zu nehmen. Dem Fachmann ist klar, dass dies auf verschiedene Art und Weise ausgeführt werden kann. Beispielsweise werden alle Düsen sämtlicher vorhandener Düsenleisten auf einer Seite im Fluid ausgebenden Modus aktiviert, während die Gesamtheit der Düsen auf der gegenüberliegenden Seite im Fluid absaugenden Modus aktiviert wird. Alternativ werden die Düsen bzw. Düsenleisten seitlich benachbarter Segmente derart gesteuert, dass direkt benachbarte Segmente nicht gleichzeitig im selben Modus aktiviert werden, wobei auch hier mit Blick auf beide Seiten gilt, dass direkt gegenüber liegende Düsen bzw. Düsenleisten oder Segmente nicht gleichzeitig im selben Modus aktiviert werden.

Zur Ausführung der alternierenden Steuerung können alle aus dem Stand der Technik bekannten Vorrichtungen eingesetzt werden. Besonders bevorzugt werden hierzu elektrische oder pneumatische Ventile sowie uni- oder bidirektional arbeitende Pumpen und dergleichen eingesetzt. Beispielsweise kann der erfindungsgemäß vorgesehene Über- bzw. Unterdruck mittels einer Pumpe bereitgestellt werden, deren Eingang mit den saugend zu betreibenden Düsenleisten, und deren Ausgang mit den ausgebend zu betreibenden Düsenleisten verbunden ist. Im Falle einer bidirektional arbeitenden Pumpe wird das erfindungsgemäße Alternieren durch einfaches Ändern der Förderrichtung der Pumpe erreicht. Im Falle einer unidirektionalen Pumpe werden entsprechend schaltbare Mehrwegeventile eingesetzt. Alternativ oder zusätzlich können auch mehrere Pumpen vorgesehen sein, welche für den jeweiligen Unter- bzw. Überdruck und/oder die jeweilige Düsenleiste zuständig sind. Durch die erfindungsgemäße alternierende Steuerung wird erreicht, dass die Abreinigung optimal verläuft. Zur Verbesserung des Ausgabe- bzw. Absaugverhaltens können zwei unterschiedliche Düsentypen vorgesehen werden. Es ist klar, dass in diesem Falle entsprechende Mittel wie z.B. Rückschlagventile vorzusehen sind, die einen jeweils nur unidirektionalen Durchfluss je Düsentyp ermöglichen. Es ist ferner klar, dass entsprechende Mittel entweder für jede Düse einzeln vorzusehen sind, oder für Gruppen von Düsen eines Typs vorliegen können, die jeweils mit einer entsprechenden gemeinsamen Zu- bzw. Abflussleitung verbunden sein müssen. Auch das Zusammenfassen von Düsen eines Typs zu entsprechenden Düsenleisten ist möglich. Ferner sind Mittel vorgesehen, die ein Fluid zu dem mindestens einen Duschelement transportieren. Für den Reinigungsprozess sind als Prozessparameter u.a. die Menge an Fluid (bzw. Flüssigkeit) und dessen Strömungsgeschwindigkeit bestimmend. Beide Parameter können über geeignete bekannte Mittel variiert werden. Erfindungsgemäß kann der Druck des Fluids an der Gesamtheit der Austrittsöffnungen eines Duschelements auf einen Wert zwischen 0,1 und 1,0 bar, vorzugsweise auf einen Wert zwischen 0,2 und 0,5 bar eingestellt werden.

Vorzugsweise zusätzlich zu den vorbeschriebenen Bewegungen des mindestens einen Duschelementes oder eines seiner Teile oder Segmente wird nun für den Reinigungsprozess, nämlich für das Entfernen der Slurry aus den Zwischenräumen, wahlweise entweder die Duscheinrichtung relativ zur feststehenden Trägereinrichtung oder die Trägereinrichtung relativ zur feststehenden Duscheinrichtung bewegt. Alternativ kann auch vorgesehen werden, dass sowohl die Trägereinrichtung als auch die Duscheinrichtung relativ zueinander bewegt werden.

Damit ein Durchfließen des Fluidstroms durch die Zwischenräume möglich ist, wird die Trägereinrichtung derart positioniert, dass die jeweils offenen Seiten zu den beiden Seitenwänden des Beckens und in Richtung des Bodens des Beckens weisen. Durch die alternierende, d.h. wechselseitige Aktivierung der erfindungsgemäßen Duscheinrichtung wird erreicht, dass die Slurry sowohl von der einen als auch von der anderen Seite aus den Zwischenräumen gespült wird.

Durch einen erhöhten Volumenstrom des Fluids ergibt sich weiterhin der Vorteil, dass die an den freien Enden zusammenklebenden Wafer in einem Abstand zueinander gehalten werden, was insbesondere durch den zuvor dargelegten gegenläufigen Betrieb in unterschiedlichen Modi verstärkt wird.

Ein weiterer Vorteil eines hohen Volumenstroms besteht darin, dass die Wafer zumindest geringfügig vibrieren, so dass sich die an der Oberfläche eines Wafers anhaftende Slurry einfacher lösen kann.

Zur weiteren Optimierung des Reinigungsprozesses ist mindestens eine Ultra- und/oder Megaschalleinrichtung vorgesehen, die innerhalb des Beckens wahlweise stationär oder bewegbar am Boden des Beckens und/oder an jedem Teil des mindestens einen Duschelements angeordnet ist. Nachfolgend wird diese Einrichtung zusammenfassend eine "Ultraschallquellen" umfassende und "Ultraschallwellen" aussendende "Ultraschalleinrichtung" genannt. Nach einer ersten Ausführungsform sind die Ultraschallquellen am Boden des Beckens angeordnet und strahlen im Wesentlichen nach oben hin in Richtung des Substratblocks ab. Nach einer anderen, alternativen oder zusätzlichen Ausführungsform sind die Ultraschallquellen an der mindestens einen Düsenleiste angeordnet und strahlen seitlich in Richtung des Substratblocks, insbesondere in die Zwischenräume einander benachbarter Substrate ab. Besonders bevorzugt sind die Ultraschallquellen zusammen mit den Düsen eines Teils des Duschelementes derart wie z.B. drehbar angeordnet, dass die Abgabe von Ultraschall und die Aktivierung der Düsen zur Ausgabe oder zum Absaugen des Fluids nacheinander erfolgen können. Für den Fachmann ist klar, dass die genannten Komponenten natürlich auch neben-, hinter- oder übereinander angeordnet sein können, sofern sie selektiv steuerbar oder aktivierbar bereitgestellt werden.

Die Ultraschallquellen können ferner schräg oder parallel zu den Wafern ausgerichtet bzw. angeordnet sein.

Dieser Ultraschall-Reinigungsprozess schließt sich vorteilhafterweise unmittelbar an den Reinigungsprozess mit dem mindestens einen Duschelement an, kann aber auch Teil desselben sein. In Abhängigkeit von der Verschmutzung der Wafer kann es jedoch auch vorteilhaft sein, diesen Reinigungsprozess vor der Behandlung mit dem mindestens einen Duschelement, also bei stehendem Fluid, durchzuführen, um beispielsweise besonders hartnäckige Verschmutzungen entsprechend vorzubehandeln. Hierzu kann es vorzusehen sein, dass entweder nur die unterhalb des Substratblocks angeordneten Ultraschallquellen, oder die an der Düsenleisten befindlichen Ultraschallquellen, oder besonders bevorzugt alle Ultraschallquellen zugleich betrieben werden. Dabei kann der Betrieb sowohl intermittierend als auch ununterbrochen erfolgen, und zwar sowohl im Hinblick auf die unterschiedlichen Ultraschallquellen (abwechselnder Betrieb einzelner Ultraschallquellen oder Ultraschallquellengruppen) als auch auf deren Gesamtheit (gleichzeitiges Ein- und Abschalten aller Ultraschallquellen). Ferner kann auch vorgesehen sein, dass insbesondere die an der Düsenleiste angeordneten Ultraschallquellen oder -einrichtungen auch während des Reinigungsvorgangs mit der Duscheinrichtung, also bei strömendem Fluid, in Betrieb sind und so der strömenden Reinigungsflüssigkeit Ultraschallschwingungen aufprägen. Dabei kann dieser unterstützende Betrieb sowohl einseitig, beispielsweise jeweils auf der ausgebenden Düsenseite, als auch beidseitig vorgesehen sein. Schließlich kann vorgesehen sein, dass die am Beckenboden angeordneten Ultraschallquellen im Megaschall- und die an der mindestens einen Duscheinrichtung angeordneten Ultraschallquellen im Ultraschallbereich abstrahlen, oder umgekehrt. Für die Durchführung dieses Prozesses ist es notwendig, dass das Becken, in dem die Trägereinrichtung angeordnet ist, mit Fluid gefüllt wird. Vorzugsweise wird ein kaltes Fluid verwendet, um eine optimale Übertragung der Ultraschallwellen zu ermöglichen. Vorzugsweise wird die Temperatur auf einen Wert zwischen 15 und 25 °C eingestellt, um chemische Reaktionen zu unterbinden und eine im Wesentlichen mechanische Behandlung zu gewährleisten.

Die Erfindung betrifft ferner ein Verfahren zum Reinigen von dünnen und/oder bruchempfindlichen Wafern mittels der vorstehend beschriebenen Vorrichtung, wobei die Wafer mit ihrer einen Seite an einer Trägereinrichtung fixiert sind und jeweils zwischen zwei benachbarten Wafern ein Zwischenraum ausgebildet ist, und wobei die Vorrichtung im Wesentlichen besteht aus einer Duscheinrichtung, mit der Fluid in die jeweiligen Zwischenräume eingebracht wird und die mindestens ein eine Mehrzahl von Düsen aufweisendes Duschelement umfasst, welches zweiteilig ausgestaltet ist, wobei jeweils ein Teil seitlich an einer Längsseite des Beckens derart angeordnet ist, dass beide Teile parallel zur Längsachse des Beckens verlaufen und hinsichtlich ihrer Strömungsrichtung gegenständig positioniert sind, einem Becken, das mit Fluid befüllbar ist und derart bemessen ist, das es die Trägereinrichtung aufnimmt, und einer alternierenden Steuerung, mit der die beiden Teile des mindestens einen Duschelementes derart steuerbar sind, dass direkt gegenüber liegende Düsen nicht gleichzeitig aktiviert werden. Das erfindungsgemäße Verfahren ist durch folgende Verfahrensschritte gekennzeichnet:
a) Einführen der Trägereinrichtung mit den Wafern in das leere oder teilgefüllte Becken;
b) Durchführen des Reinigungsprozesses mit der Duscheinrichtung, wobei die Aktivierung das Ausgeben oder Absaugen von Fluid betrifft.

Nach einer bevorzugten Ausführungsform umfasst das erfindungsgemäße Verfahren als zusätzlichen Verfahrensschritt c) das Durchführen des Reinigungsprozesses mit einer Ultraschalleinrichtung in Anwesenheit von Fluid, wobei dieser Schritt wahlweise auch vor dem Verfahrensschritt a) durchgeführt werden kann.

Nach dieser ggfs. vorgeschalteten Ultraschallbehandlung des Substratblocks wird das Becken entleert, und ein weiterer Reinigungsprozess mit dem mindestens einen Duschelement beginnt, wobei diese Reinigung durch Beaufschlagen des Fluids mit Ultra- und/oder Megaschall unterstützt werden kann. Der Prozess kann je nach Bedarf wiederholt werden, indem sich die Zyklen "Reinigungsprozess mit Duschelement" und "Reinigungsprozess mit Ultraschall" entsprechend abwechseln.

Eine besondere Ausbildung der Erfindung sieht vor, dass der Substratblock zunächst unter Verwendung der Duscheinrichtung mit einem warmen, gewünschtenfalls geeignete chemische Zusätze wie z.B. Tenside enthaltenden Fluid gereinigt wird, wobei dessen Temperatur vorzugsweise zwischen 35 und 40°C beträgt. Anschließend findet die Ultraschallreinigung innerhalb eines kalten Fluids statt. Beide Prozesse wiederholen sich gegebenenfalls.

Als letzter Prozess ist ein Reinigungsprozess unter Verwendung der Duscheinrichtung mit einem kalten Fluid vorgesehen. Letzteres bringt den Vorteil mit sich, dass durch das Duschen mit einem kalten Fluid verhindert wird, dass die Wafer "austrocknen" und so eventuell übrig gebliebene Slurry fest an den Wafern anhaftet.

Das Duschfluid ist erfindungsgemäß wässrig und wird vorzugsweise auf eine Temperatur zwischen 15 und 40°C eingestellt, wobei eine Temperatur zwischen 30 und 40°C besonders bevorzugt ist. Vorzugsweise umfasst es geeignete nicht-schäumende, nicht-ionische Tenside in einer Menge von 0 bis 1 Vol.%, wobei eine Menge von 0,1 bis 0,5 Vol.%, bezogen auf die gesamte Fluidmenge, besonders bevorzugt ist. Vorzugsweise weist das bzw. weisen die Tenside einen (gemittelten) pH-Wert von etwa 13,0 auf, wodurch der pH-Wert des Duschfluids vorteilhaft auf einen bevorzugten Wert kleiner 12,0, besonders bevorzugt auf einen Wert zwischen 10,5 und 11,0 eingestellt werden kann. Ferner kann das Duschfluid Lauge oder Säure sowie gewünschtenfalls weitere Chemikalien umfassen.

Gewünschtenfalls kann das erfindungsgemäße Verfahren in einer bevorzugten Ausführungsform noch einen weiteren Verfahrensschritt der Kleberablösung umfassen. Hierzu wird die Trägereinrichtung ggfs. mit der Hilfseinrichtung in ein Behandlungsbecken überführt, welches eine in Abhängigkeit von der Beschaffenheit des verwendeten Klebers geeignete Flüssigkeit beinhaltet. Als besonders geeignet hat sich beispielsweise die Verwendung einer Essigsäure enthaltenden wässrigen Flüssigkeit erwiesen, deren Temperatur und pH-Wert besonders bevorzugt auf Werte um 40°C bzw. 3,0 bis 4,0 eingestellt sind. Anschließend werden die Wafer gespült, was vorzugsweise dadurch erfolgt, dass sie mit der Hilfseinrichtung in ein mit Wasser gefülltes Spülbecken überführt werden. Dieser Prozess kann wiederum durch die oben genannte mindestens eine Ultra- und/oder Megaschalleinrichtung unterstützt werden.

Ein weiterer wesentlicher Vorteil des Verfahrens ist, dass es sich in einen nachfolgenden Bearbeitungsprozess der Wafer einfach eingliedern lässt. Besonders vorteilhaft hat sich herausgestellt, dass die Prozessparameter erfindungsgemäß genau und reproduzierbar eingestellt werden können, wodurch die Behandlung auch größerer Stückzahlen auf gleichem Qualitätsniveau ermöglicht wird.

Weitere vorteilhafte Ausgestaltungen gehen aus der nachfolgenden Beschreibung sowie den Zeichnungen und den Ansprüchen hervor.

### Zeichnungen

Es zeigen:
- Fig. 1: eine schematische Ansicht der Trägereinrichtung 2, im Wesentlichen bestehend aus dem zu reinigenden Substratblock 1;
- Fig. 2: eine perspektivische Ansicht einer Hilfseinrichtung 8 zur Aufnahme der Trägereinrichtung 2 gemäß Fig. 1;
- Fig. 3: eine perspektivische Ansicht einer Hilfseinrichtung 8, gegenüber Fig. 2 mit der bereits aufgenommenen Trägereinrichtung 2;
- Fig. 4: eine schematische Ansicht eines bevorzugten Ausführungsbeispiels der erfindungsgemäßen Vorrichtung mit Duscheinrichtung in Form eines zweiteiligen Duschelementes 16;
- Fig. 5: eine schematische Ansicht eines bevorzugten Ausführungsbeispiels der erfindungsgemäßen Vorrichtung mit Duschelement 16, jedoch gegenüber Fig. 4 bereits mit eingefügter Trägereinrichtung in Ausgangslage (A); eine schematische Ansicht eines weiteren bevorzugten Ausführungsbeispiels mit genauerer Darstellung von Ultraschalleinrichtung 18 und beidseitig angeordnetem Duschelement 16 (B); eine schematische Darstellung des Duschelementes 16 mit Ultraschalleinrichtung 17 und Düsen zur Ausgabe und Absaugen von Fluid (C).

### Beschreibung eines Ausführungsbeispiels

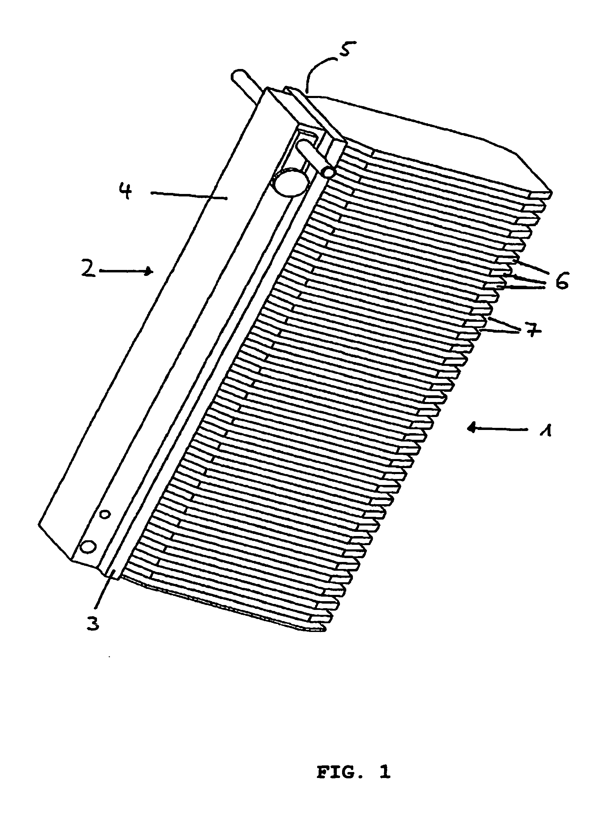

In Fig. 1 ist ein zu reinigender Substratblock 1 dargestellt. Der Substratblock 1 ist auf einer Trägereinrichtung 2 aufgebracht, die aus einer Glassplatte 3 sowie einem Befestigungselement 4 besteht. Der Substratblock 1 ist bei dem hier dargestellten Ausführungsbeispiel mit seiner einen Seite 5 flächig auf der Glasplatte 3 aufgeklebt. Durch den bereits durchgeführten Sägeprozess, dessen Schnitte bis in die Glasplatte 3 hineinreichen, entstehen einzelne Substrate, die auch als Wafer 6 bezeichnet werden. Zwischen den einzelnen Wafern 6 entsteht jeweils ein Zwischenraum 7, in dem sich die sogenannte Slurry (in den Zeichnungen nicht dargestellt) befindet, die durch den erfindungsgemäßen Reinigungsprozess entfernt werden soll.

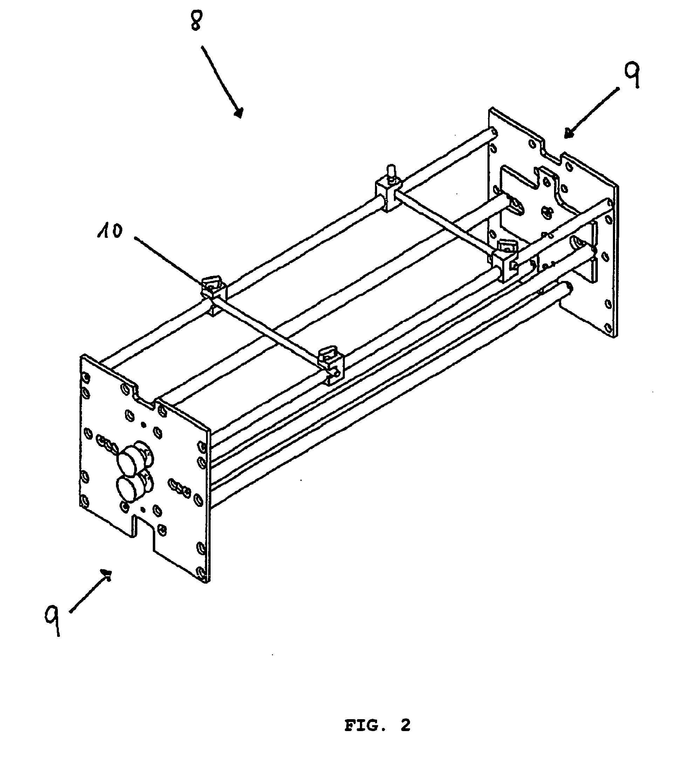

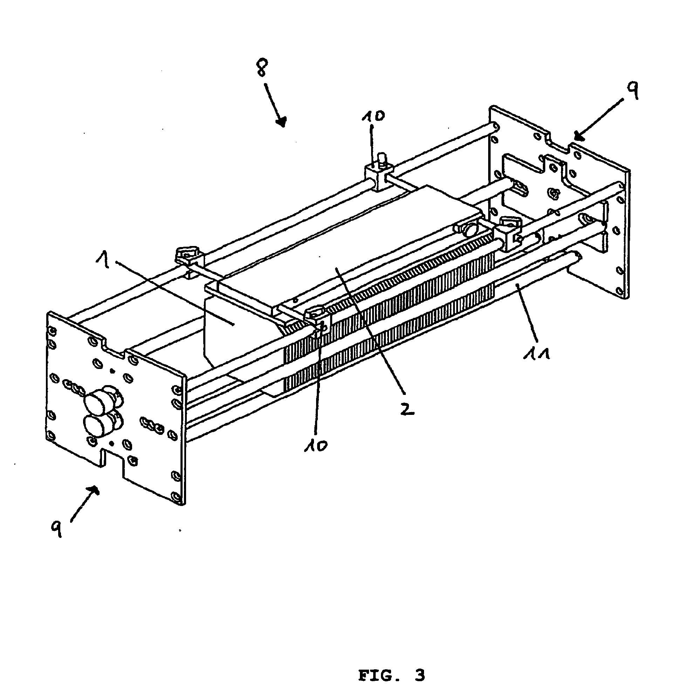

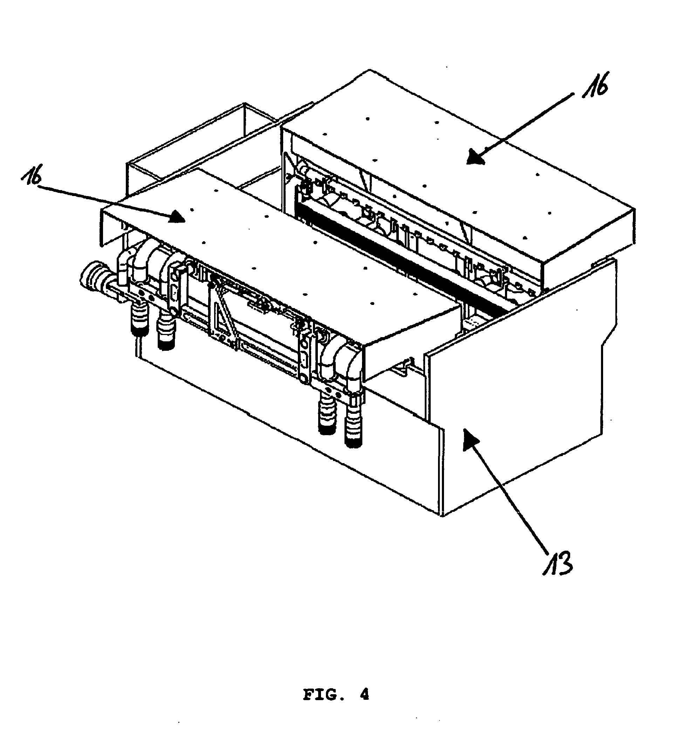

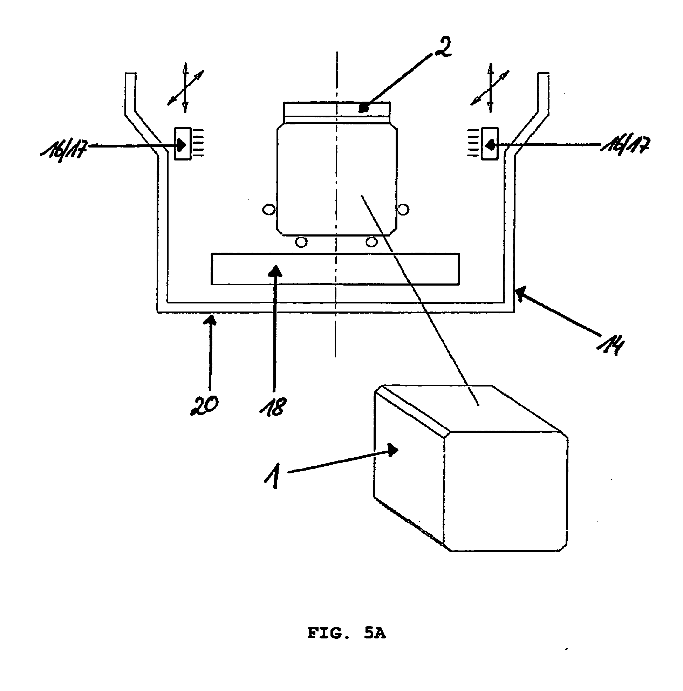

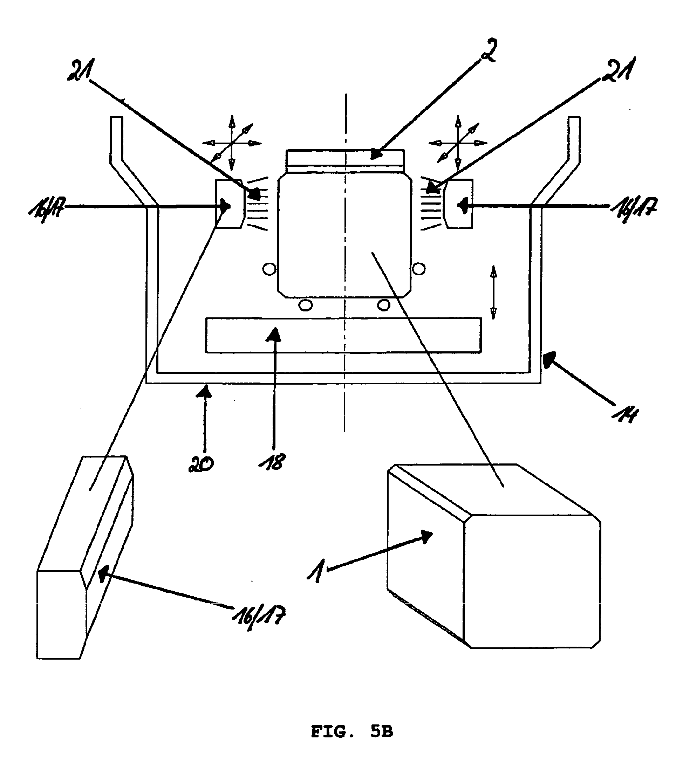

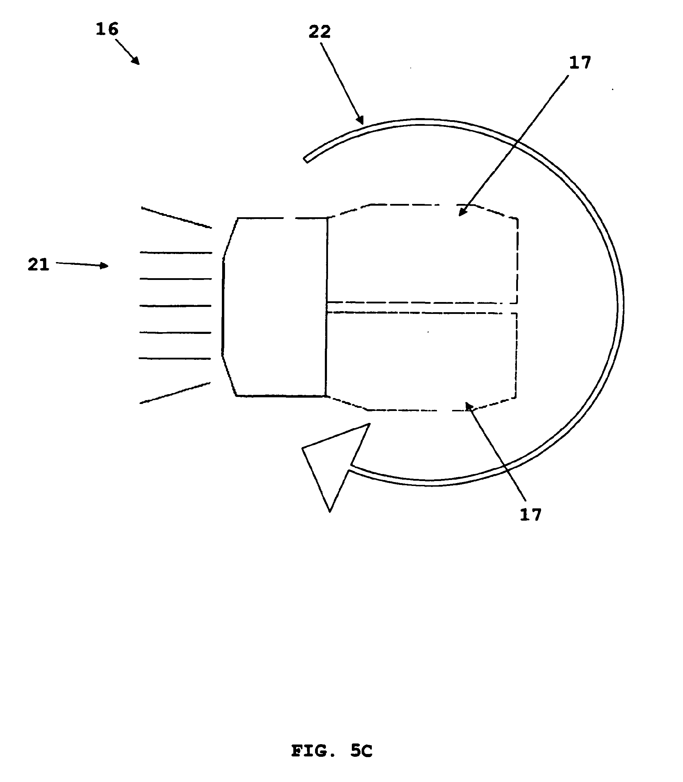

Um den mit der Trägereinrichtung 2 verbundenen Substratblock 1 an die erfindungsgemäße Vorrichtung, wie sie in den Fig. 4 und 5 dargestellt ist, übergeben zu können, wird die Trägereinrichtung 2 mit einer Hilfseinrichtung 8, wie sie in Fig. 2 und 3 dargestellt ist, übergeben. Vorzugsweise umfasst die Hilfseinrichtung 8 seitlich angeordnete Mittel 9, die mit der Vorrichtung gemäß den Fig. 4 und 5 zusammenwirken. Um unterschiedlich große Trägereinrichtungen 2 aufnehmen zu können, ist vorgesehen, eine Aufnahmeeinrichtung 10 bereitzustellen, die flexibel in ihrer Lage zur Aufnahme der Trägereinrichtung 2 positionierbar ist. Zudem ist die Hilfseinrichtung 8 derart gestaltet, dass der Substratblock 1 gemäß Darstellung in Fig. 3 eine geschützte Lage gegen ungewolltes Anstoßen an einen Gegenstand einnimmt. Bei dem hier dargestellten Ausführungsbeispiel sind Stangen 11 als Verbindungselemente zwischen den vorgesehenen Mitteln 9 angeordnet, die den Substratblock 1 zwischen sich einschließen.

Um den Reinigungsprozess durchzuführen, ist die Vorrichtung 12 gemäß Darstellung in Fig. 5 mit der Hilfseinrichtung 8 zu beladen. Die Vorrichtung 12 selbst zeigt ein Gehäuse 13, das ein mit einem Fluid befüllbares Becken 14 umfasst. Das Becken 14 ist derart bemessen, dass die Hilfseinrichtung 8 vollständig von dem Becken 14 aufgenommen werden kann.

Das Becken 14 ist vorzugsweise derart ausgestaltet, dass es die Hilfseinrichtung 8 an den entsprechenden Mitteln 9 aufnehmen kann.

Ferner weist die Vorrichtung 12 eine Duscheinrichtung 15 auf. Die Duscheinrichtung 15 besteht im Wesentlichen aus einem Duschelement 16, das zweiteilig ausgebildet ist und sich parallel zur Längserstreckung der Trägereinrichtung 2 erstreckt.

Bei dem in Fig. 5A und 5B dargestellten Ausführungsbeispiel wird das Duschelement 16 während der Ultraschallbehandlung eingesetzt, um eine förderliche Querströmung auszubilden. Es weist düsenartige Ausbildungen auf, die innerhalb des Beckens 14 zur Reinigung des Substratblocks 1 eine Querströmung erzeugen.

Ferner ist auf der Bodenseite des Gehäuses 13 eine Ultraschalleinrichtung 18 mit Ultraschallquellen vorgesehen. Diese Ultraschalleinrichtung 18 wird je nach Bedarf zu- oder abgeschaltet und dient dazu, zusätzlich die in den Zwischenräumen 7 befindliche Slurry aufzulockern bzw. zu entfernen.

Alternativ zu der in Fig. 5 dargestellten Ultraschalleinrichtung 18 kann vorgesehen werden, dass anstelle des stationären festen Einbaus eine mobile Ultraschalleinrichtung vorgesehen ist, die auch innerhalb des Beckens 14 in beliebiger Stellung verfahrbar ist.

In der Fig. 5C ist eine Detailansicht eines erfindungsgemäßen Duschelements 16 dargestellt. Der Fluidstrom 21 tritt hier in horizontaler Richtung auf der linken Seite des Duschelements aus, welches hierzu entsprechende Düsen umfasst (nicht dargestellt). In den rechts oben und unten mit einer unterbrochenen Linienführung dargestellten Bereichen sind zwei Komponenten angeordnet, die vorzugsweise dieselbe Geometrie wie das Duschelement aufweisen. Nach einer bevorzugten Ausführungsform kennzeichnen diese Bereiche die Funktionalitäten einer Ultraschalleinrichtung 17 und einer Absaugeinrichtung. Alternativ können diese Bereiche die Funktionalitäten einer Ultraschalleinrichtung und einer Megaschallquelle aufweisen, die in der dargestellten Lage nach oben bzw. unten abstrahlen, wobei das Duschelement in diesem Fall bauartbedingt Fluid sowohl ausgeben als auch absaugen können muss. Um die entsprechenden Teile des dargestellten Duschelements erfindungsgemäß in optimaler Weise zu verwenden, sind die Ultraschalleinrichtung 17 zusammen mit den Düsen eines Teils des Duschelementes 16 derart wie z.B. drehbar angeordnet, dass die Abgabe von Ultraschall und die Aktivierung der Düsen zur Ausgabe oder zum Absaugen des Fluids nacheinander erfolgen können. Für den Fachmann ist klar, dass die genannten Komponenten natürlich auch neben-, hinter- oder übereinander angeordnet sein können, sofern sie selektiv steuerbar oder aktivierbar bereitgestellt werden.

### Funktionsweise:

Der Reinigungsprozess gestaltet sich wie folgt:

Nachdem die Trägereinrichtung 2 zusammen mit der Hilfseinrichtung 8 in die Vorrichtung 12 eingebracht worden ist (Fig. 5), nimmt die Trägereinrichtung 2 eine Stellung ein, durch die die einzelnen Wafer 6 in Richtung des Bodens 20 gerichtet sind. Dies bedeutet, dass die Zwischenräume 7 jeweils zu den Seiten und in Richtung Boden 20 des Beckens 14 offen sind.

Der Reinigungsprozess beginnt bevorzugt, indem der Substratblock zunächst für eine gewisse Zeit im mit Reinigungsfluid gefüllten Becken mit Ultra- und/oder Megaschall, ggf. auch abwechselnd, bestrahlt wird. Auf diese Weise wird bereits eine Lockerung der abzureinigenden Slurry erreicht.

Anschließend wird die Duscheinrichtung 15 aktiviert. Der aus dem Duschelement 16 austretende Fluidstrom 21 gelangt in die jeweiligen Zwischenräume 7, fließt durch diese zumindest teilweise hindurch, um dann in Richtung Boden 20 des Beckens 14 wieder auszutreten bzw. von den gegenüberliegenden, im Absaugmodus aktivierten Düsen abgesogen zu werden.

Besonders bevorzugt werden während der Reinigung mit dem Flüssigkeitsstrom und/oder Ultraschall mittels der oben beschriebenen speziellen Düsenform und/oder eines speziell dafür vorgesehenen Systems Gasblasen aktiv in den Flüssigkeitsstrom eingebracht. Ebenfalls besonders bevorzugt findet dabei eine horizontale, parallel zur Erstreckung des Substratblocks verlaufende Bewegung der Düsen bzw. Düsenleisten statt. Durch die zuvor detailliert dargelegte erfindungsgemäße Vorgehensweise kann die Slurry aus den jeweiligen Zwischenräumen 7 entfernt werden. Je nach Verschmutzungsgrad kann dieser Reinigungsprozess, welcher ggf. auch die Reinigung mit Ultraschall umfassen kann, beliebig oft wiederholt werden. Der Fluidstrom 21 selbst ist vorzugsweise temperiert und kann Temperaturen zwischen 25 Grad und 40 Grad Celsius aufweisen.

Anschließend findet nach einer bevorzugten Ausführungsform eine erneute Ultraschallreinigung mit der Ultraschalleinrichtung 18 statt. Hierzu ist es wiederum notwendig, dass das Becken 14 zur Übertragung der Schallwellen von den Ultraschallquellen mit einem Fluid gefüllt wird.

Im Anschluss hieran wird das Becken 14 entleert und der bereits beschriebene Duschvorgang, ggfs. unter ebenfalls vorangehender und/oder anschließender Ultra- und/oder Megaschallbestrahlung, beginnt nötigenfalls erneut. Auf diese Weise können sich die einzelnen Schritte beliebig wiederholen. Vor der Entnahme des dann gereinigten Substratblocks 1 findet vorzugsweise nochmals ein Duschvorgang statt, jedoch mit einem kalten Fluid. Dadurch kann verhindert werden, dass noch vorhandene Slurry zumindest unmittelbar antrocknet.

Durch die erfindungsgemäße Vorrichtung 1 und das Anwenden des erfindungsgemäßen Verfahrens ist es möglich geworden, dünne, bruchempfindliche Scheiben selbsttätig (automatisch) zu reinigen. Insbesondere bei der Herstellung von Wafern für die Halbleiter- und Solarindustrie ist es notwendig, die sogenannte Slurry unmittelbar nach dem Sägeprozess zu entfernen. Diese Slurry haftet sehr stark an der Oberfläche des jeweiligen Wafers, weshalb bisher eine manuelle Behandlung durchgeführt werden musste. Durch das erfindungsgemäße Verfahren ist es jedoch möglich geworden, eine qualitativ sehr gute und automatisierte Reinigung der Wafer 6 zu ermöglichen.

Die vorliegende Erfindung wurde im Hinblick auf die Behandlung von Siliziumwafern dargelegt. Selbstverständlich können auch scheibenförmige Substrate aus anderen Materialien wie z.B. Kunststoff erfindungsgemäß bearbeitet werden.

### BEZUGSZEICHENLISTE

1. Substratblock
2. Trägereinrichtung
3. Glasplatte
4. Befestigungselement
5. eine Seite
6. Wafer
7. Zwischenraum
8. Hilfseinrichtung
9. Mittel
10. Aufnahmeeinrichtung
11. Stangen
12. Vorrichtung
13. Gehäuse
14. Becken
15. Duscheinrichtung
16. Duschelement
17. Ultraschalleinrichtung / Düsenleiste
18. Ultraschalleinrichtung / Becken
19. Ultraschallquellen
20. Boden
21. Fluidstrom
22. Rotationspfeil

## Patentansprüche

1. Vorrichtung zum Reinigen von dünnen und/oder bruchempfindlichen Wafern (6), wobei die Wafer (6) mit ihrer einen Seite an einer Trägereinrichtung (2) fixiert sind und jeweils zwischen zwei benachbarten Wafern ein Zwischenraum (7) ausgebildet ist, bestehend im Wesentlichen aus:
- einer Duscheinrichtung (15), mit der Fluid in die jeweiligen Zwischenräume (7) eingebracht wird, mit mindestens einem eine Mehrzahl von Düsen aufweisenden Duschelement (16), welches zweiteilig ausgestaltet ist, wobei jeweils ein Teil seitlich an einer Längsseite des Beckens (14) derart angeordnet ist, dass beide Teile parallel zur Längsachse des Beckens verlaufen und hinsichtlich ihrer Strömungsrichtung gegenständig positioniert sind, sowie
- einem Becken (14), das mit Fluid befüllbar und derart bemessen ist, das es die Trägereinrichtung (2) aufnimmt, und
- einer alternierenden Steuerung, mit der die beiden Teile des mindestens einen Duschelementes (16) unabhängig voneinander aktivierbar sind,
**dadurch gekennzeichnet, dass** die beiden Teile des mindestens einen Duschelementes (16) sowohl mit einem Überdruck zum Ausgeben als auch mit einem Unterdruck zum Absaugen von Fluid aktivierbar sind.

2. Vorrichtung nach Anspruch 1, **dadurch gekennzeichnet, dass** die Düsen jeweils eines Teils des Duschelementes (16) funktionell über mindestens eine Düsenleiste miteinander in Verbindung stehen und somit mit demselben Über- oder Unterdruck beaufschlagbar sind.

3. Vorrichtung nach Anspruch 1 oder 2, **dadurch gekennzeichnet, dass** das mindestens eine Duschelement (16) beidseitig in mehrere Segmente unterteilt ist, die jeweils eine Düsenleiste aufweisen.

4. Vorrichtung nach einem der Ansprüche 1 bis 3, **dadurch gekennzeichnet, dass** die Position beider Teile des Duschelementes (16), gegebenenfalls getrennt voneinander, verstellbar ist.

5. Vorrichtung nach einem der vorhergehenden Ansprüche, **dadurch gekennzeichnet, dass** wahlweise entweder die Duscheinrichtung (15) relativ zur feststehenden Trägereinrichtung (2), oder die Trägereinrichtung (2) relativ zur feststehenden Duscheinrichtung (15), oder sowohl die Trägereinrichtung (2) als auch die Duscheinrichtung (15) relativ zueinander bewegbar sind.

6. Vorrichtung nach einem der vorhergehenden Ansprüche, **dadurch gekennzeichnet, dass** mindestens eine Ultraschalleinrichtung (18) vorgesehen ist, die innerhalb des Beckens (14) wahlweise stationär oder bewegbar angeordnet ist.

7. Vorrichtung nach einem der vorhergehenden Ansprüche, **dadurch gekennzeichnet, dass** jedes Teil des mindestens einen Duschelementes (16) mindestens eine Ultra- oder Megaschalleinrichtung aufweist.

8. Vorrichtung nach einem der vorhergehenden Ansprüche, **dadurch gekennzeichnet, dass** sie ferner ein System zur aktiven Einbringung von Gasblasen in den Strom der von den Düsen ausgegebenen Reinigungsflüssigkeit aufweist, wobei die Gasblasen vorzugsweise eine Größe zwischen 1 und 500 µm aufweisen.

9. Vorrichtung nach einem der Ansprüche 6 bis 8, **dadurch gekennzeichnet, dass** die Ultraschalleinrichtung zusammen mit den Düsen eines Teils des Duschelementes (16) derart angeordnet und steuerbar sind, dass die Abgabe von Ultraschall und die Aktivierung der Düsen zur Ausgabe oder zum Absaugen des Fluids nacheinander erfolgen können.

10. Verfahren zum Reinigen von dünnen und/oder bruchempfindlichen Wafern (6) mittels einer Vorrichtung, wobei die Wafer (6) mit ihrer einen Seite an einer Trägereinrichtung (2) fixiert sind und jeweils zwischen zwei benachbarten Wafern ein Zwischenraum (7) ausgebildet ist, und wobei die Vorrichtung im Wesentlichen besteht aus einer Duscheinrichtung (15), mit der Fluid in die jeweiligen Zwischenräume (7) eingebracht wird und die mindestens ein eine Mehrzahl von Düsen aufweisendes Duschelement (16) umfasst, welches zweiteilig ausgestaltet ist, wobei jeweils ein Teil seitlich an einer Längsseite des Beckens (14) derart angeordnet ist, dass beide Teile parallel zur Längsachse des Beckens verlaufen und hinsichtlich ihrer Strömungsrichtung gegenständig positioniert sind, einem Becken (14), das mit Fluid befüllbar und derart bemessen ist, das es die Trägereinrichtung (2) aufnimmt, und einer alternierenden Steuerung, mit der die beiden Teile des mindestens einen Duschelementes (16) unabhängig voneinander aktivierbar sind, **dadurch gekennzeichnet, dass** die beiden Teile des mindestens einen Duschelementes (16) sowohl mit einem Überdruck zum Ausgeben als auch mit einem Unterdruck zum Absaugen von Fluid aktivierbar sind und der Reinigungsprozesses mit der Duscheinrichtung (15) nach Einführen der Trägereinrichtung (2) mit den Wafern (6) in das leere oder teilgefüllte Becken (14) unter Aktivierung beider Teile des Duschelementes derart durchgeführt wird, dass direkt gegenüber liegende Düsen des Duschelementes nicht gleichzeitig im selben Modus aktiviert werden.

11. Verfahren nach Anspruch 10, **dadurch gekennzeichnet, dass** es als zusätzlichen Verfahrensschritt das Durchführen des Reinigungsprozesses mit einer Ultraschalleinrichtung (17; 18) in Anwesenheit von Fluid umfasst.

12. Verfahren nach Anspruch 10 oder 11, **dadurch gekennzeichnet, dass** während des Reinigungsprozesses eine aktive Einbringung von Gasblasen in den Strom der von den Düsen ausgegebenen Reinigungsflüssigkeit erfolgt, wobei die Gasblasen vorzugsweise eine Größe zwischen 1 und 500 µm aufweisen.

## Claims

1. Apparatus for the cleaning of thin and/or fragile wafers (6), wherein the wafers (6) are fixed with one side to a carrier device (2), and wherein an interspace (7) is formed between two adjacent wafers (6), substantially consisting of:
- a shower device (15), by which fluid is injected into the respective interspaces (7), with at least one shower element (16) having a plurality of nozzles and a two-part design with each respective part being arranged laterally at one long side of the basin (14) in such a manner that both parts run parallel to the longitudinal axis of the basin and, with respect to their flow direction, are positioned in opposing directions;
- a basin (14) that can be filled with fluid and that is dimensioned such that it houses the carrier device (2); and
- an alternating control, by which said both parts of said at least one shower element (16) can be activated independently from each other;
**characterized in that** said both parts of the at least one shower element (16) can be activated both with a high pressure for the emittance and with a low pressure for the suction of fluid.

2. Apparatus according to claim 1, **characterized in that** the nozzles of each respective part of the shower element (16) are functionally connected to each other via at least one nozzle bar so that they can therefore be charged with the same high or low pressure.

3. Apparatus according to claim 1 or 2, **characterized in that** the at least one shower element (16) is divided into several segments on both sides, wherein each of the segments has one nozzle bar.

4. Apparatus according to any of claims 1 to 3, **characterized in that** the position of both parts of the shower element (16) is, optionally separately from each other, adjustable.

5. Apparatus according to any of the preceding claims, **characterized in that** either the shower device (15) can be moved in relation to the immobile carrier device (2), or the carrier device (2) can be moved in relation to the immobile shower device (15), or the carrier device (2) as well as the shower device (15) can be moved in relation to each other.

6. Apparatus according to any of the preceding claims, **characterized in that** at least one ultrasonic device (18) is provided that is arranged within the basin (14) optionally immobile or movable.

7. Apparatus according to any of the preceding claims, **characterized in that** each part of the at least one shower element (16) comprises at least one ultrasonic or megasonic device.

8. Apparatus according to any of the preceding claims, **characterized in that** it further comprises a system for the active introduction of gas bubbles into the stream of the cleaning liquid emitted by the nozzles, wherein the gas bubbles preferably have a size between 1 and 500 µm.

9. Apparatus according to any of claims 6 to 8, **characterized in that** the ultrasonic device together with the nozzles of one part of the shower element (16) are arranged and controllable such that the delivery of ultrasound and the activation of the nozzles for the
emittance or suction of the fluid can be effected one after the other.

10. Method for the cleaning of thin and/or fragile wafers (6) by means of an apparatus, wherein the wafers (6) are fixed with one side to a carrier device (2), and wherein an interspace (7) is formed between two adjacent wafers, and wherein the apparatus substantially consists of a shower device (15) by which fluid is injected into the respective interspaces (7) and which comprises at least one shower element (16) having a plurality of nozzles and a two-part design with each respective part being arranged laterally at one long side of the basin (14) in such a manner that both parts run parallel to the longitudinal axis of the basin and, with respect to their flow direction, are positioned in opposing directions, a basin (14) that can be filled with fluid and that is dimensioned such that it houses the carrier device (2), and an alternating control by which said both parts of said at least one shower element (16) can be activated independently from each other, **characterized in that** said both parts of the at least one shower element (16) can be activated both with a high pressure for the emittance and with a low pressure for the suction of fluid, and that the cleaning process with the shower device (15) after insertion of the carrier device (2) with the wafers (6) into the empty or partly filled basin (14) is carried out upon activation of both parts of the shower element in such a manner that directly opposing nozzles of the shower element are not activated in the same mode simultaneously.

11. Method according to claim 10, **characterized in that** it comprises as an additional step the carrying out of the cleaning process with an ultrasonic device (17; 18) in the presence of fluid.

12. Method according to claim 10 or 11, **characterized in that** an active introduction of gas bubbles into the stream of the cleaning liquid emitted by the nozzles takes place during the cleaning process, wherein the gas bubbles preferably have a size between 1 and 500 µm.

## Revendications

1. Dispositif pour le nettoyage de plaquettes fines et/ou cassables (6), les plaquettes étant fixées par un de leur coté à un dispositif porteur (2) et un interstice (7) étant formé entre chaque paire de plaquettes voisines, constitué principalement par :
- un dispositif de douche (15), grâce auquel un fluide est injecté dans les interstices correspondants (7), avec au moins un élément de douche (16) comprenant plusieurs gicleurs, lequel est conçu en deux parties, chaque partie étant localisée latéralement sur le grand coté du bassin (14) de telle manière que les deux parties sont parallèles à l'axe longitudinal du bassin et en opposition en ce qui concerne le sens d'écoulement,
- un bassin (14) qui peut être rempli de fluide et de dimensions telles qu'il intègre le dispositif porteur (2), et
- une commande alternée avec laquelle les deux parties du, au moins un, élément de douche (16) sont activables indépendamment l'une de l'autre,
**caractérisé en ce que** les deux parties du, au moins un, élément de douche (16) sont activables aussi bien en surpression pour émettre un fluide qu'en dépression pour aspirer un fluide.

2. Dispositif selon la revendication 1, **caractérisé en ce que** les gicleurs respectifs d'une partie de l'élément de douche (16) sont connectés fonctionnellement les uns aux autres par au moins une barrette à gicleurs et ainsi peuvent être alimentés avec la même surpression ou dépression.

3. Dispositif selon la revendication 1 ou la revendication 2, **caractérisé en ce que** le, au moins un, élément de douche (16) est divisé des deux cotés en plusieurs segments qui chacun présentent une barrette à gicleur.

4. Dispositif selon une des revendications 1 à 3, **caractérisé en ce que** la position des deux parties de l'élément de douche (16) est ajustable, en option séparément l'une de l'autre.

5. Dispositif selon une des revendications précédentes, **caractérisé en ce que** au choix, ou bien le dispositif de douche (15) est ajustable par rapport au dispositif porteur (2) fixe, ou bien le dispositif porteur (2) est ajustable par rapport au dispositif de douche (15) fixe, ou encore aussi bien le dispositif porteur (2) que le dispositif de douche (15) sont ajustables l'un par rapport à l'autre.

6. Dispositif selon une des revendications précédentes, **caractérisé en ce que** au moins un dispositif à ultrasons (18) est prévu, localisé à l'intérieur du bassin (14), au choix stationnaire ou mobile.

7. Dispositif selon une des revendications précédentes, **caractérisé en ce que** chaque partie du, au moins un, élément de douche (16) contient au moins un dispositif à ultra- ou à mega-sons.

8. Dispositif selon une des revendications précédentes, **caractérisé en ce que** il contient en plus un système pour l'apport actif de bulles gazeuses dans le flux de liquide nettoyant émis par les gicleurs, les bulles gazeuses ayant de préférence une taille comprise entre 1 et 500 µm.

9. Dispositif selon une des revendications 6 à 8, **caractérisé en ce que** le dispositif à ultrasons ensemble avec les gicleurs d'une partie de l'élément de douche (16), sont localisés et réglables de telle manière que l'émission d'ultrasons et l'activation des gicleurs pour l'émission ou l'aspiration du fluide peuvent survenir l'une après l'autre.

10. Procédé pour le nettoyage de plaquettes fines et/ou cassables (6) au moyen d'un dispositif, les plaquettes (6) étant fixées par un de leurs cotés à un dispositif porteur (2) et un interstice (7) étant formé entre chaque paire de plaquettes voisines, et le dispositif étant constitué principalement par un dispositif de douche (15) grâce auquel un fluide est injecté dans les interstices correspondants (7) et qui comprend au moins un élément de douche (16) avec plusieurs gicleurs, lequel est conçu en deux parties, chaque partie étant localisée latéralement sur le grand coté du bassin (14) de telle manière que les deux parties sont parallèles à l'axe longitudinal du bassin et en opposition en ce qui concerne le sens d'écoulement, un bassin (14) qui peut être rempli de fluide et de dimensions telles qu'il peut intégrer le dispositif porteur (2), et une commande alternée par laquelle les deux parties du, au moins un, élément de douche (16) sont activables indépendamment l'une de l'autre, **caractérisé en ce que** les deux parties du, au moins un, élément de douche (16) sont activables aussi bien en surpression pour l'émission de fluide que en dépression pour l'aspiration de fluide et le processus de nettoyage avec le dispositif de douche (15) après introduction du dispositif porteur (2) avec les plaquettes (6) dans le bassin (14) vide ou partiellement rempli est effectué par l'activation des deux parties de l'élément de douche de telle manière que les gicleurs de l'élément de douche positionnés en vis à vis ne sont pas activés en même temps sur le même mode.

11. Procédé selon la revendication 10, **caractérisé en ce que** il comprend une étape de procédé supplémentaire consistant en la mise en oeuvre du processus de nettoyage avec un dispositif à ultrasons (17,18) en présence de fluide.

12. Procédé selon la revendication 10 ou la revendication 11, **caractérisé en ce que** pendant le processus de nettoyage, un apport actif de bulles gazeuses dans le flux de liquide nettoyant émis par les gicleurs est mis en oeuvre, les bulles gazeuses ayant de préférence une taille comprise entre 1 et 500 µm.
